# EUROPEAN PATENT APPLICATION

(11) **EP 4 790 444 A1**
(43) Date of publication of application: **12.08.2026**
(21) Application number: 25817117.2
(22) Date of filing: 20.11.2025
(51) Int. Cl.: G01R 35/02

(54) **ONLINE PREDICTION METHOD AND APPARATUS FOR METERING ERROR OF ELECTRONIC CURRENT TRANSFORMER**

(30) Priority: 20.12.2024 CN 202411884676
(71) Applicant: State Grid Zhejiang Tongxiang Electric Power Supply Company, Jiaxing, Zhejiang 314500 (CN)
(72) Inventor: LIU, Guoliang, Jiaxing, Zhejiang 314500 (CN); YANG, Bo, Jiaxing, Zhejiang 314500 (CN); XU, Hong, Jiaxing, Zhejiang 314500 (CN); LI, Xin, Jiaxing, Zhejiang 314500 (CN); TANG, Xuyao, Jiaxing, Zhejiang 314500 (CN); ZHANG, Guofeng, Jiaxing, Zhejiang 314500 (CN); LU, Changtang, Jiaxing, Zhejiang 314500 (CN)
(74) Representative: Elzaburu S.L.P.
(86) International application number: PCT/CN2025/136337
(87) International publication number: WO 2026/130014

(57) **Abstract**

The present invention provides a method and an apparatus for online prediction of a measurement error of an electronic current transformer. The method includes: obtaining environmental data of an environment where the electronic current transformer is located, and obtaining error data of the electronic current transformer in an automatic prediction manner by a neural network, thereby implementing online automatic prediction of an error of the electronic current transformer, improving efficiency for determining the error of the electronic current transformer, and further enhancing calibration efficiency of the electronic current transformer. Further, a target swimming penetration neural network includes a retention layer, and the retention layer is used to store an output from a hidden layer in a previous iteration. Compared with a conventional neural network, a structure of this retention layer can effectively enhance both the overall and local stability of the swimming penetration neural network, thereby improving accuracy of error prediction by the electronic current transformer.

## Description

### FIELD OF TECHNOLOGY

The present invention relates to the technical field of artificial intelligence, and in particular to a method and an apparatus for online prediction of a measurement error of an electronic current transformer.

### BACKGROUND

Driven by digital transformation of the national power grid, electronic current transformers, as one of the main digital intelligent metering devices, are widely used in digital intelligent substations due to a simple insulation structure, a wide measurement bandwidth, and a large dynamic range. A digital interface of the electronic current transformers is more conducive to multimodal data fusion and sharing, meeting the needs of substation digitalization development. As a core device for next-generation current signal data acquisition in substations, measurement accuracy of the electronic current transformers is critical to power metering.

Therefore, in practical applications, it is necessary to regularly calibrate power metering devices. In related technologies, a deviation between a device under metering and a high-accuracy reference instrument is compared to determine an error of a measurement value of the device under metering, thereby ensuring the accuracy and safety reliability of all metering devices. However, in this approach, a connected current transformer directly affects calibration accuracy, resulting in high dependence on a current transformer with high accuracy requirements.

Therefore, periodic offline calibration is performed for power current transformers in a current power system. However, an offline calibration approach involves complex field wiring, a high calibration difficulty, and low work efficiency. In addition, compared with conventional electromagnetic current transformers, the electronic current transformers are more severely affected by various environmental factors, resulting in low reliability and stability, and thus requiring a shorter calibration cycle. Further, due to requirements for safe and economical operation of a power grid, it is necessary to arrange short-cycle power outage plans, which further increases a difficulty in performing offline calibration work. There is an urgent need to develop a new online calibration method for the electronic current transformers.

### SUMMARY

In view of the above, embodiments of the present invention provide a method and an apparatus for online prediction of a measurement error of an electronic current transformer, to improve calibration efficiency of the electronic current transformer.

According to one aspect of the present invention, a method for online prediction of a measurement error of an electronic current transformer is provided, including:
obtaining target environmental data of an environment where a target electronic current transformer is located, where the target environmental data includes temperature data, humidity data, magnetic field data, and corrosion data; and
inputting the target environmental data into a pre-trained target swimming penetration neural network to obtain an error prediction result output by a target error prediction model based on the target environmental data, where the error prediction result includes a ratio error prediction result and a phase error prediction result;
the target swimming penetration neural network is pre-trained in the following steps:
obtaining an environmental dataset, where each environmental data entry and an error label of the electronic current transformer corresponding to each environmental data entry are included in the environmental dataset;
inputting each environmental data entry in the environmental dataset into an initial swimming penetration neural network to obtain a predicted error output by the initial swimming penetration neural network, where the initial swimming penetration neural network includes an input layer, a latent layer, a retention layer, and an output layer, and the retention layer is used to receive an output from the latent layer and store an output from the latent layer in a previous iteration; and
training parameters in the initial swimming penetration neural network based on a difference between the predicted error and the error label corresponding to the environmental data until the difference converges, thereby obtaining the target swimming penetration neural network, where the parameters include inter-layer connection weights between network layers and biases in the network layers.

In one possible embodiment, the obtaining an environmental dataset includes:
obtaining historically acquired operating status data of the electronic current transformer and corresponding environmental data, where the operating status data includes a ratio difference and a phase difference of the electronic current transformer; and
filtering out an erroneous value and outlier from the operating status data of the electronic current transformer according to a preset filtering rule, to obtain filtered operating status data and corresponding environmental data, which form the environmental dataset, where the erroneous value means operating status data that appears consecutively more than a preset times threshold, and the outlier means operating status data whose difference from another piece of operating status data exceeds a preset status difference threshold.

In one possible embodiment, the initial swimming penetration neural network includes multiple latent layers and multiple retention layers, each latent layer is in a one-to-one correspondence with each retention layer, and the training parameters in the initial swimming penetration neural network based on a difference between the predicted error and the error label corresponding to the environmental data includes:
calculating a range of the number of latent layers based on the number of nodes in the input layer, the number of nodes in the output layer, and a preset node perturbation number, where the number of nodes in the input layer is the number of data types input to the input layer, the number of nodes in the output layer is the preset number of data types output by the output layer, and the preset node perturbation number is a constant within a preset value range;
obtaining candidate latent layer counts based on a range of the number of latent layers, where the candidate latent layer counts are all integer values within the range; and
for each of the candidate latent layer counts, calculating an error deviation value based on the predicted error and the error label corresponding to the environmental data, and determining a candidate latent layer count corresponding to a minimum error deviation value in error deviation values corresponding to each of the candidate latent layer counts as the target number of latent layers and the target number of retention layers.

In one possible embodiment, the training parameters in the initial swimming penetration neural network based on a difference between the predicted error and the error label corresponding to the environmental data further includes:
setting spatial dimensions of the inter-layer connection weights and bias particles, and using a particle swarm algorithm to determine optimal values of the inter-layer connection weights and optimal values of the biases, where spatial dimensions of the inter-layer connection weights and the bias particles and the total number of particles are determined by the following formulas: ${S}_{N} \left(t\right) = {n}_{h} \left(t\right) \left({r}_{1}{n}_{in}\left(t\right)+{r}_{2}{n}_{out}\left(t\right)+{n}_{h}\left(t\right)+1\right) + {r}_{2} {n}_{out} \left(t\right)$ $P \left(t\right) = int \left({r}_{1}+{r}_{2}\sqrt{{S}_{N} \left(t\right)}\right)$
where *S_{N}*(*t*) is the spatial dimensions, *nₕ*(*t*) is the target number of the latent layers, *n*ᵢₙ(*t*) is the number of nodes in the input layer, *n*ₒᵤₜ(*t*) is the number of nodes in the output layer, r1 and r2 are random numbers; and *P*(*t*) is the total number of particles.

In one possible embodiment, the using a particle swarm algorithm to determine optimal values of the inter-layer connection weights and optimal values of the biases includes:
generating multiple particles in space corresponding to the spatial dimensions, where the total number of multiple particles is the number of particles; and
updating a velocity and position of each particle in each iteration according to the following formulas: ${v}_{ij} \left(t+1\right) = {wv}_{ij} \left(t\right) + {c}_{1} {r}_{1} \left[{p}_{ij}^{best}\left(t\right)-{p}_{ij}\left(t\right)\right] + {c}_{2} {r}_{2} \left[{g}_{j}^{best}\left(t\right)-{p}_{ij}\left(t\right)\right] + {δr}_{3} \left(t\right)$ ${p}_{ij} \left(t+1\right) = {p}_{ij} \left(t\right) + {v}_{ij} \left(t+1\right)$
where i is the number of particles, j is the spatial dimensions, vᵢⱼ(t) is a velocity of the particle after t iterations, pᵢⱼ(t) is a position of the particle after t iterations, ${p}_{ij}^{best} \left(t\right)$ is a j-th dimension value of an i-th particle's extremum, ${g}_{j}^{best} \left(t\right)$ is a j-th dimension value of a global optimal position, r₁, r₂, r₃ are random numbers in [0,1]; c₁ is an individual learning factor, c₂ is a social learning factor, w is an inertia weight, and δ is a random influence factor;

The inertia weight is iterated according to the following formula: $w \left(t\right) = \left({w}_{max}-{w}_{min}\right) \frac{{N}_{c} \left(t\right)}{{N}_{m} \left(t\right)} + {w}_{max} + σ \left(t\right)$
where w(t) is the inertia weight after t iterations, *wₘₐₓ* is a preset maximum value of the inertia weight, *wₘᵢₙ* is a preset minimum value of the inertia weight, *N_{c}*(*t*) is the current number of iteration steps, Nₘ (t) is the preset maximum number of iteration steps, and σ(*t*) is a random perturbation value;
the individual learning factor and the social learning factor are iterated according to the following formulas: ${c}_{1} \left(t\right) = {c}_{max} \left(t\right) - \frac{{N}_{c} \left(t\right) \left({c}_{max}\left(t\right)-{c}_{min}\left(t\right)\right)}{{N}_{m} \left(t\right)} + {σ}_{1} \left(t\right)$ ${c}_{2} \left(1\right) = {c}_{min} \left(t\right) + \frac{{N}_{c} \left(t\right) \left({c}_{max}\left(t\right)-{c}_{min}\left(t\right)\right)}{{N}_{m} \left(t\right)} + {σ}_{2} \left(t\right)$
where *c*₁(*t*) is a value of the individual learning factor after t iterations, *cₘₐₓ*(*t*) is a preset maximum value of the learning factor, and *σ*₁(*t*) and *σ*₂(*t*) are both perturbation factors; and
after each update of the velocity and position of each particle, a target loss function value is calculated based on a current velocity and position of the particle, and if a minimum value of the target loss function has not been reached, a step of updating the velocity and position of each particle in each iteration according to the following formula is returned, until the minimum value of the target loss function is obtained.

In one possible embodiment, the inputting the target environmental data into a pre-trained target swimming penetration neural network to obtain an error prediction result output by a target error prediction model based on the target environmental data includes:
outputting, by the target swimming penetration neural network, the error prediction result according to the following function: $y \left(k, t\right) = {g}^{1} \left({ω}_{3}\left(u\left(k, t\right)\right)\right) + σ \left(k, t\right)$ $u \left(k, t\right) = {g}^{2} \left({ω}_{1}{u}_{c}\left(k, t\right)+{ω}_{2}x\left(k-1,t\right)\right) + σ \left(k, t\right)$ ${u}_{c} \left(k, t\right) = u \left(k-1,t\right)$
where *y*(*k, t*) is an output of the target swimming penetration neural network, *x(k - 1, t)* is the target environmental data, *u*(*k, t*) is an output amount from the latent layer, *u_{c}*(*k, t*) is an output amount from the latent layer to the retention layer, *ω*₁ and *ω*₂ are the inter-layer connection weights, k is the number of iterations, *g*¹() is a neuron activation function of the output layer, *g*²() is a neuron activation function of the latent layer, and *σ*(*k, t*) is a perturbation function.

In one possible embodiment, the method further includes:
using a preset validation set to evaluate the target swimming penetration neural network based on preset statistical indicators, where the preset statistical indicators include an absolute error Ea of a stochastic mean field technique and a mean relative error Er, and the absolute error of the stochastic mean field technique is calculated by the following formula: ${E}_{a} = \frac{1}{n} \sqrt{{\sum }_{i = 1}^{n} {c}_{i} {\left({y}_{i}-{e}_{i}\right)}^{2}} \times 100 %$
where *cᵢ* is a preset prediction standard coefficient, *yᵢ* is the error label corresponding to the environmental data, *eᵢ* is a predicted error value, and n is the number of environmental data entries input to the target swimming penetration neural network; and
the mean relative error is calculated by the following formula: ${E}_{r} = \frac{1}{n} \sqrt{{\sum }_{i = 1}^{n} \frac{{c}_{i} {\left({y}_{i}-{e}_{i}\right)}^{2}}{{y}_{i}}} \times 100 %$
when the preset statistical indicators are less than preset thresholds, it is determined that the training of the target swimming penetration neural network is completed.

According to another aspect of the present invention, an apparatus for online prediction of a measurement error of an electronic current transformer is provided, including:
an obtaining module, configured to obtain target environmental data of an environment where a target electronic current transformer is located, where the target environmental data includes temperature data, humidity data, magnetic field data, and corrosion data; and
an input module, configured to input the target environmental data into a pre-trained target swimming penetration neural network to obtain an error prediction result output by a target error prediction model based on the target environmental data, where the error prediction result includes a ratio error prediction result and a phase error prediction result, where
the target swimming penetration neural network is pre-trained in the following steps:
obtaining an environmental dataset, where each environmental data entry and an error label of the electronic current transformer corresponding to each environmental data entry are included in the environmental dataset;
inputting each environmental data entry in the environmental dataset into an initial swimming penetration neural network to obtain a predicted error output by the initial swimming penetration neural network, where the initial swimming penetration neural network includes an input layer, a latent layer, a retention layer, and an output layer, and the retention layer is used to receive an output from the latent layer and store an output from the latent layer in a previous iteration; and
training parameters in the initial swimming penetration neural network based on a difference between the predicted error and the error label corresponding to the environmental data until the difference converges, thereby obtaining the target swimming penetration neural network, where the parameters include inter-layer connection weights between network layers and biases in the network layers.

According to another aspect of the present invention, an electronic device is provided, including:
a processor; and
a memory storing a program,
where the program includes instructions that, when executed by the processor, cause the processor to perform the method for online prediction of a measurement error of an electronic current transformer described in any of the above.

According to another aspect of the present invention, a non-transitory computer-readable storage medium storing computer instructions is provided, where the computer instructions are used to cause a computer to perform the method for online prediction of a measurement error of an electronic current transformer described in any of the above.

In one or more technical solutions of the present invention, environmental data of an environment where the electronic current transformer is located is obtained, and the error data of the electronic current transformer is obtained in an automatic prediction manner by the neural network, thereby implementing online automatic prediction of the error of the electronic current transformer, improving efficiency for determining the error of the electronic current transformer, and further enhancing calibration efficiency of the electronic current transformer. Further, a target swimming penetration neural network includes a retention layer, and the retention layer is used to store an output from a hidden layer in a previous iteration. Compared with a conventional neural network, a structure of this retention layer can effectively enhance both the overall and local stability of the swimming penetration neural network, thereby improving accuracy of error prediction by the electronic current transformer.

### BRIEF DESCRIPTION OF THE DRAWINGS

Further details, features, and advantages of the present invention are disclosed in the following description of exemplary embodiments with reference to drawings, in which
FIG. 1 is a schematic flow diagram of a method for online prediction of a measurement error of an electronic current transformer according to an embodiment of the present invention;
FIG. 2 is a schematic flow diagram of a training process of a target swimming penetration neural network in the method for online prediction of a measurement error of an electronic current transformer according to an embodiment of the present invention;
FIG. 3 is a schematic diagram of an architecture of a network platform for implementing the method for online prediction of a measurement error of an electronic current transformer according to an embodiment of the present invention;
FIG. 4 is a schematic structural diagram of the target swimming penetration neural network according to an embodiment of the present invention;
FIG. 5 is a schematic structural diagram of an apparatus for online prediction of a measurement error of an electronic current transformer according to an embodiment of the present invention; and
FIG. 6 is a block diagram of an exemplary electronic device that can be configured to implement embodiments of the present invention.

### DESCRIPTION OF THE EMBODIMENTS

Embodiments of the present invention will be described below in further detail with reference to the accompanying drawings. Although some embodiments of the present invention are shown in the drawings, it should be understood that the present invention can be implemented in various forms and should not be construed as confined to the embodiments set forth herein, but rather provided for more thoroughly and completely understanding the present invention. It should be understood that the drawings and embodiments of the present invention are for illustrative purposes only and are not intended to limit the scope of protection of the present invention.

It should be understood that the steps described in method implementations of the present invention may be executed in different sequences and/or in parallel. In addition, the method implementations may include additional steps and/or omit steps performed or shown. The scope of the present invention is not limited in this regard.

The term "include" and variations used herein are open, namely, "including but not limited to". The term "based on" means "at least partially based on". The term "one embodiment" means "at least one embodiment"; the term "another embodiment" means "at least one another embodiment"; the term "some embodiments" means "at least some embodiments". Related definitions of other terms are given in the following descriptions. It should be noted that concepts "first", "second", and the like mentioned in the present invention are only used to distinguish different apparatuses, modules, or units, and are not used to define an order or interdependence of functions performed by these apparatuses, modules, or units.

It should be noted that modifiers of "one" and "a plurality of" mentioned in the present invention are indicative and not restrictive, and those skilled in the art should understand that the modifiers should be understood as "one or more" unless otherwise expressly specified.

Names of messages or information exchanged between a plurality of apparatuses in implementations of the present invention are for illustrative purposes only and are not intended to limit the scope of such messages or information.

An electronic current transformer is an apparatus including one or more voltage sensors or current sensors connected to a transmission system and a secondary converter, configured to transmit a signal proportional to a quantity being measured to a measuring instrument, a meter, and a relay protection or control apparatus. The electronic current transformer may have a measurement error due to environmental influences. Because a power system cannot be offline for a long period, it is necessary to calibrate the electronic current transformer by measuring the error online and performing calibration accordingly.

To improve calibration efficiency of the electronic current transformer, embodiments of the present invention provide a method and an apparatus for online prediction of a measurement error of an electronic current transformer. The method for online prediction of a measurement error of an electronic current transformer provided in an embodiment of the present invention can be used in any electronic device with an online prediction function for the measurement error of the electronic current transformer, such as a computer, a server, or a mobile terminal. Solutions of the present invention are described below with reference to drawings:

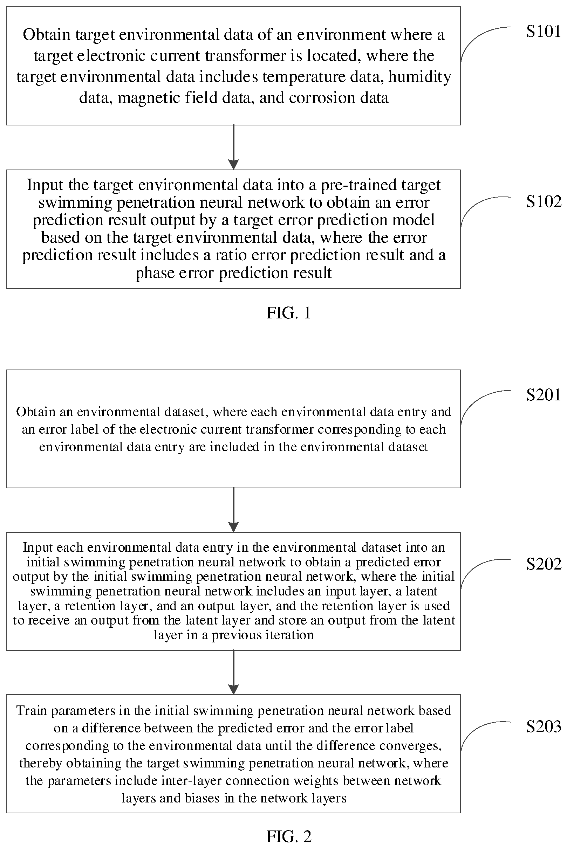

FIG. 1 is a schematic flow diagram of a method for online prediction of a measurement error of an electronic current transformer according to an embodiment of the present invention, which may include the following steps:
S101: Obtaining target environmental data of an environment where a target electronic current transformer is located, where the target environmental data includes temperature data, humidity data, magnetic field data, and corrosion data; and
S102: Inputting the target environmental data into a pre-trained target swimming penetration neural network to obtain an error prediction result output by a target error prediction model based on the target environmental data, where the error prediction result includes a ratio error prediction result and a phase error prediction result.

In one possible embodiment, as shown in FIG. 2, the above target swimming penetration neural network may be pre-trained through the following steps:
S201: Obtaining an environmental dataset, where each environmental data entry and an error label of the electronic current transformer corresponding to each environmental data entry are included in the environmental dataset;
S202: Inputting each environmental data entry in the environmental dataset into an initial swimming penetration neural network to obtain a predicted error output by the initial swimming penetration neural network, where the initial swimming penetration neural network includes an input layer, a latent layer, a retention layer, and an output layer, and the retention layer is used to receive an output from the latent layer and store an output from the latent layer in a previous iteration; and
S203: Training parameters in the initial swimming penetration neural network based on a difference between the predicted error and the error label corresponding to the environmental data until the difference converges, thereby obtaining the target swimming penetration neural network, where the parameters include inter-layer connection weights between network layers and biases in the network layers.

The embodiments of the present invention are applied, the environmental data of the environment where the electronic current transformer is located is obtained, and the error data of the electronic current transformer is obtained in an automatic prediction manner by the neural network, thereby implementing online automatic prediction of the error of the electronic current transformer, improving efficiency for determining the error of the electronic current transformer, and further enhancing calibration efficiency of the electronic current transformer. Further, a target swimming penetration neural network includes a retention layer, and the retention layer is used to store an output from a hidden layer in a previous iteration. Compared with a conventional neural network, a structure of this retention layer can effectively enhance both the overall and local stability of the swimming penetration neural network, thereby improving accuracy of error prediction by the electronic current transformer.

The target electronic current transformer in the present invention may be any electronic current transformer. In one possible embodiment, a time counter may be disposed when each electronic current transformer is activated. The time counter is configured to monitor usage time of the electronic current transformer and can designate the electronic current transformer whose usage time exceeds a preset time threshold as the target electronic current transformer for error prediction. In one possible embodiment, error prediction for each electronic current transformer in the power system may also be performed according to a preset time cycle. The above time threshold and time cycle can both be set according to actual application scenarios, which are not specifically limited in the present invention.

When error prediction is performed on the target electronic current transformer, target environmental data of the environment where the target electronic current transformer is located can be obtained first. The target environmental data may include the temperature data, the humidity data, the magnetic field data, the corrosion data, and the like. For example, the target environmental data may also include data such as vibration, an electric field load, a frequency, a harmonic wave, communication, and security.

The above target environmental data can be acquired and obtained by various sensors. For example, the temperature data can be acquired by a temperature sensor, and the temperature data may include an ambient temperature and a corresponding acquisition timestamp. The humidity data can be acquired by a humidity sensor, and the humidity data may include an ambient humidity and a corresponding acquisition timestamp. The above magnetic field data may include magnetic field information generated by various power devices in the environment where the target electronic current transformer is located, geomagnetic field information, and the like, and the magnetic field information may include a magnetic field intensity, a magnetic field direction, and the like. The above corrosion data may include various factors that may cause corrosion to the electronic current transformer, such as a temperature, a humidity, a pollutant concentration, a wind speed, and the like. For example, the corrosion data can be acquired by a corrosion sensor, and the corrosion sensor can measure parameters such as a corrosion potential and a current density.

The sensors may be installed inside the target electronic current transformer or in close proximity to the electronic current transformer, such as one meter away from the target electronic current transformer, to obtain the target environmental data of the environment where the target electronic current transformer is located as accurately as possible. In one possible embodiment, the target environmental data may include environmental data acquired within preset duration. The preset duration can be set according to actual application scenarios, such as one day, three days, or the like.

After the target environmental data is obtained, the target environmental data can be input into the pre-trained target swimming penetration neural network. In one possible embodiment, after the target swimming penetration neural network is pre-trained, the target swimming penetration neural network can be loaded onto an edge computing device. The edge computing device means an electronic device included in a preset big data intelligent monitoring platform and located close to the target electronic current transformer. The edge computing device is used to predict the error of the target electronic current transformer, so that a data transmission path can be shortened, thereby improving the efficiency of error prediction.

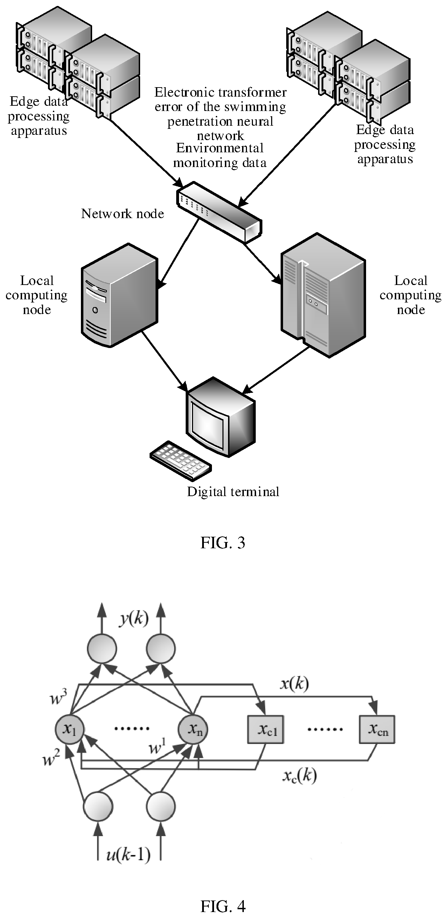

FIG. 3 is a schematic structural diagram of a network monitoring platform for implementing the method for online prediction of a measurement error of an electronic current transformer according to an embodiment of the present invention. Specifically, the error data of the electronic current transformer from the swimming penetration neural network and monitored corrosion data are acquired and calculated by a data processing apparatus, and edge real-time error comparison and monitoring are performed by using a big data intelligent monitoring platform.

The above target electronic current transformer is obtained through the pre-training in step S201 to step S203. In S201, the environmental dataset may include historically acquired environmental data of an environment where various electronic current transformers are located and the error conditions of the electronic current transformers corresponding to the environmental data. The above environmental data may include the temperature data, the humidity data, the magnetic field data, the corrosion data, and the like. Because a measurement object of the electronic current transformer is usually an alternating current, correspondingly, the error conditions of the above electronic current transformer may include a ratio error and a phase error, where the ratio error may include an error between an output of the electronic current transformer and an amplitude of an original current.

In one possible embodiment, a correspondence between the error and the environmental data may be constructed based on a timestamp. For example, the error of the electronic current transformer can be represented by four input variables and two output variables at a time point t: $\left\{\begin{matrix}δ \left(t\right) = {f}_{1} \left({x}_{1}\left(t\right),{x}_{2}\left(t\right),{x}_{3}\left(t\right),{x}_{4}\left(t\right)\right) \pm {ε}_{1} \left(t\right) \\ γ \left(t\right) = {f}_{2} \left({x}_{1}\left(1\right),{x}_{2}\left(2\right),{x}_{3}\left(3\right),{x}_{4}\left(t\right)\right) \pm {ε}_{2} \left(t\right)\end{matrix}\right.$
where *δ*(*t*) and *γ*(*t*) represent the ratio error and phase error at the time point t respectively, *x*₁(*t*), *x*₂(*t*), x*₃*(*t*), x₄(*t*) represent the temperature data, the humidity data, the magnetic field data, and the corrosion data at the time point t, respectively, *ε*₁(*t*) and *ε*₂(*t*) represent perturbation errors caused by other pieces of environmental data, and specific values of the perturbation errors can be determined based on specific values of other pieces of environmental data.

The following can be obtained based on the above formula: $\left\{\begin{matrix}{F}_{1} \left(t\right) = X \left(t\right) {B}_{1} \left(t\right) \pm {ε}_{1} \left(t\right) \\ {F}_{2} \left(t\right) = X \left(t\right) {B}_{2} \left(t\right) \pm {ε}_{2} \left(t\right)\end{matrix}\right.$
where *F*₁(*t*) *=* [*δ*₁, *δ*₂, ··· , δₙ]*^{T}* , *F*(*t*)₂ *=* [γ₁, γ₂, ··· ,γ*ₙ*]*^{T}* , X(t)=[*x*₁(1 ... *n*), x₂(1 ... n), *x₃*(1 ... *n*), *x*₄(1 *... n*)]*^{T}*, B1 and B2 are transformation matrices to be solved for the ratio error and the phase error with respect to the environmental data. In the above X(t), *F₁*(*t*) and *F*(*t*)₂ form the environmental dataset.

In one possible embodiment, the above environmental dataset may be obtained in the following steps:
S211: Obtaining historically acquired operating status data of the electronic current transformer and corresponding environmental data, where the operating status data includes a ratio difference and a phase difference of the electronic current transformer; and
S212: Filtering out an erroneous value and outlier from the operating status data of the electronic current transformer according to a preset filtering rule, to obtain filtered operating status data and corresponding environmental data, which form the environmental dataset, where the erroneous value means operating status data that appears consecutively more than a preset times threshold, and the outlier means operating status data whose difference from another piece of operating status data exceeds a preset status difference threshold.

Due to network conditions, the operating status data (namely, the above error conditions) of the electronic current transformer may experience storage delay during storage and transmission, resulting in multiple repetitions of data storage and leading to an erroneous value in the stored operating status data. Therefore, when the environmental dataset is constructed, such data can be filtered. Specifically, if the same operating status data appears consecutively more than a preset times threshold, it can be determined that the operating status data is erroneous data, and thus the operating status data and the corresponding environmental data can be deleted. To be specific, if operating status data whose order keeps changing but ratio difference and related phase difference remain unchanged, it can be determined that the data is erroneous data, and such erroneous data can be removed from a storage system during data analysis.

The outlier means operating status data whose difference from another piece of operating status data exceeds a preset status difference threshold. For example, due to a problem of the electronic current transformer itself or a network transmission problem, an operating status may deviate significantly from a normal range, and the operating status is irrelevant to a neural network's learning of a relationship between the operating status of the electronic current transformer and the environmental data and may instead lead to model overfitting. Therefore, these pieces of operating status data that deviate significantly from the normal range can be removed.

According to the above technical solutions, data is effectively filtered. An introduced abnormal value that affects measurement error accuracy of the electronic current transformer in the swimming penetration neural network, and data that deviates significantly from a data direction reflecting an error characteristic but does not belong to abnormal data are filtered out in a data filtering method, to remove non-normal data from the measurement dataset. This enables accurate analysis of the error characteristic of the electronic current transformer.

After the environmental dataset is obtained, each environmental data entry can be input into the initial swimming penetration neural network. The initial swimming penetration neural network includes an input layer, a latent layer, a retention layer, and an output layer. The latent layer is used to compress an input from the input layer into hidden space to extract a feature of input data. The retention layer, which has a temporal delay property, is used to receive an output from the latent layer and store an output from the latent layer in a previous iteration, thereby feeding back the output from the hidden layer in the previous iteration into a current training cycle. This enhances network's learning of a sequential feature of input data and effectively improves both the overall and local stability of the swimming penetration neural network.

Each of the above network layers includes an inter-layer connection weight, the inter-layer connection weight is used to weight the output of the network layer before the output is input into a next layer. Each network layer also includes a bias, and the bias is used to add a random perturbation value to the output of the network layer to prevent model overfitting.

In one possible embodiment, an input/output functional relationship of the swimming penetration neural network can be expressed as follows: $y \left(k, t\right) = {g}^{1} \left({ω}_{3}\left(u\left(k, t\right)\right)\right) + σ \left(k, t\right)$ $u \left(k, t\right) = {g}^{2} \left({ω}_{1}{u}_{c}\left(k, t\right)+{ω}_{2}x\left(k-1,t\right)\right) + σ \left(k, t\right)$ ${u}_{c} \left(k, t\right) = u \left(k-1,t\right)$
where *y*(*k, t*) is an output of the target swimming penetration neural network, *x*(*k - 1, t*) is the target environmental data, *u*(*k, t*) is an output amount from the latent layer, *u_{c}*(*k, t*) is an output amount from the latent layer to the retention layer, *ω*₁ and *ω*₂ are the inter-layer connection weights, k is the number of iterations, *g*¹() is a neuron activation function of the output layer, which can specifically be $\frac{1}{1 + {e}^{x}}$, x is a function input, *g*²() is a neuron activation function of the latent layer, which can specifically be $\frac{1 + {e}^{- x}}{1 + {e}^{x}}$, and *σ*(*k, t*) is a perturbation function.

There are multiple latent layers and multiple retention layers, and each latent layer corresponds to each retention layer. To be specific, output data from the latent layer is input into a unique retention layer. Correspondingly, the number of latent layers and the number of retention layers are the same. FIG. 4 is a schematic structural diagram of the latent layers and retention layers included in the initial swimming penetration neural network. The latent layer outputs data to the retention layer, and the retention layer can feed back the previous output data of the latent layer to the latent layer.

In one possible embodiment, the number of latent layers and retention layers can be determined in the following steps.

S221: Calculating a range of the number of latent layers based on the number of nodes in the input layer, the number of nodes in the output layer, and a preset node perturbation number, where the number of nodes in the input layer is the number of data types input to the input layer, the number of nodes in the output layer is the preset number of data types output by the output layer, and the preset node perturbation number is a constant within a preset value range.

For example, if the environmental data includes the temperature data, the humidity data, the magnetic field data, and the corrosion data, the number of nodes in the input layer is 4. If an output prediction results include a ratio error and a phase error, the number of nodes in the output is 2. A value range of the node perturbation number can be preset according to practical application scenarios, such as a constant within [3,10].

In a possible implementation, the range of the number can be calculated by the following formula: ${n}_{h} \left(t\right) = \sqrt{{n}_{in} \left(t\right) + {n}_{out} \left(t\right)} + {c}_{h} \left(t\right)$
where *n*ᵢₙ(*t*) is the number of nodes in the input layer, *n*ₒᵤₜ(*t*)is the number of nodes in the output layer, and *cₙ*(*t*)is the preset node perturbation number.

S222: Obtaining candidate latent layer counts based on a range of the number of latent layers, where the candidate latent layer counts are all integer values within the range.

S223: For each of the candidate latent layer counts, calculating an error deviation value based on the predicted error and the error label corresponding to the environmental data, and determining a candidate latent layer count corresponding to a minimum error deviation value in error deviation values corresponding to each of the candidate latent layer counts as the target number of latent layers and the target number of retention layers.

For example, each integer value within the above range can be used in turn as the candidate latent layer count to participate in the output predicted error, and a candidate latent layer count corresponding to a minimum difference is determined as a target count based on a difference between an error output by a neural network and a corresponding error label.

A difference between the predicted error and the error label can be obtained by a target loss function. In a possible implementation, the target loss function can be: $E \left(k, t\right) = \sqrt{{\sum }_{i = 1}^{n} {r}_{i} \left(k, t\right) {\left[{y}_{i}\left(k, t\right)-{e}_{i}\left(k, t\right)\right]}^{2}}$
where *eᵢ*(*k, t*) is the error label, *yᵢ*(*k, t*) is the predicted error output by the swimming penetration neural network, *rᵢ*(*k, t*)is a normalization factor, n is the number of environmental data entries input into the target swimming penetration neural network.

As described above, parameters included in the swimming penetration neural network may include the inter-layer connection weights between network layers and biases within the network layers. In one possible implementation, optimal values of the above inter-layer connection weights and optimal values of the biases can be determined using a PSO algorithm (also referred to as a particle swimming penetration optimization, PSPO algorithm). The PSO algorithm is an optimization method based on swarm intelligence. The PSO algorithm simulates a foraging behavior of bird flocks in nature, treating solution space of a problem as multidimensional space, where each potential solution is abstracted as one "particle." In a possible implementation, the optimal values of the inter-layer connection weights between the network layers and the optimal values of the biases within the network layers can be determined in the following steps:

Setting spatial dimensions of the inter-layer connection weights and bias particles, and using a particle swarm algorithm to determine optimal values of the inter-layer connection weights and optimal values of the biases, where spatial dimensions of the inter-layer connection weights and the bias particles and the total number of particles are determined by the following formulas: ${S}_{N} \left(t\right) = {n}_{h} \left(t\right) \left({r}_{1}{n}_{in}\left(t\right)+{r}_{2}{n}_{out}\left(t\right)+{n}_{h}\left(t\right)+1\right) + {r}_{2} {n}_{out} \left(t\right)$ $P \left(t\right) = int \left({r}_{1}+{r}_{2}\sqrt{{S}_{N} \left(t\right)}\right)$
where *S_{N}*(*t*) is the spatial dimensions, *nₕ*(*t*) is the target number of the latent layers, *n*ᵢₙ(*t*) is the number of nodes in the input layer, *n*ₒᵤₜ(*t*) is the number of nodes in the output layer, r1 and r2 are random numbers; and *P*(*t*) is the total number of particles;
Generating multiple particles in space corresponding to the spatial dimensions, where the total number of multiple particles is the number of particles; and
Updating a velocity and position of each particle in each iteration according to the following formulas: ${v}_{ij} \left(t+1\right) = {wv}_{ij} \left(t\right) + {c}_{1} {r}_{1} \left[{p}_{ij}^{best}\left(t\right)-{p}_{ij}\left(t\right)\right] + {c}_{2} {r}_{2} \left[{g}_{j}^{best}\left(t\right)-{p}_{ij}\left(t\right)\right] + {δr}_{3} \left(t\right)$ ${p}_{ij} \left(t+1\right) = {p}_{ij} \left(t\right) + {v}_{ij} \left(t+1\right)$
where i is the number of particles, j is the spatial dimensions, vᵢⱼ(t) is a velocity of the particle after t iterations, pᵢⱼ(t) is a position of the particle after t iterations, ${p}_{ij}^{best} \left(t\right)$ is a j-th dimension value of an i-th particle's extremum, ${g}_{j}^{best} \left(t\right)$ is a j-th dimension value of a global optimal position, r₁, r₂, r₃ are random numbers in [0,1]; c₁ is an individual learning factor, c₂ is a social learning factor, w is an inertia weight, and δ is a random influence factor;

The inertia weight reflects a particle's search capability in the PSO algorithm. Setting a larger inertia weight at an initial stage of the algorithm can reduce a time period for a particle to find an optimal position, while a smaller inertia weight is needed in a later stage of the algorithm to find a local optimum. For example, the inertia weight is iterated according to the following formula: $w \left(t\right) = \left({w}_{max}-{w}_{min}\right) \frac{{N}_{c} \left(t\right)}{{N}_{m} \left(t\right)} + {w}_{max} + σ \left(t\right)$
where w(t) is the inertia weight after t iterations, *wₘₐₓ* is a preset maximum value of the inertia weight, *w*ₘᵢₙ is a preset minimum value of the inertia weight, *N_{c}*(*t*) is the current number of iteration steps, Nₘ (t) is the preset maximum number of iteration steps, and *σ*(*t*) is a random perturbation value. The above maximum value and minimum value of the inertia weights and maximum number of iteration steps can all be set according to an actual application scenario.

In an initial stage of a swimming penetration particle swarm iteration, none of the particles have found the optimal solution. In this case, emphasis is placed on individual learning to autonomously search for the optimal solution through swimming penetration. After the iteration ends, some penetrating particles have found the optimal solution, and the optimal solution is then sought based on broad information of the swimming particle swarm. Therefore, at a time point t, the individual learning factor *c*₁(*t*) should gradually decrease, while the social learning factor *c*₂(*t*) should gradually increase.

The individual learning factor and the social learning factor are iterated according to the following formulas: ${c}_{1} \left(t\right) = {c}_{max} \left(t\right) - \frac{{N}_{c} \left(t\right) \left({c}_{max}\left(t\right)-{c}_{min}\left(t\right)\right)}{{N}_{m} \left(t\right)} + {σ}_{1} \left(t\right)$ ${c}_{2} \left(t\right) = {c}_{min} \left(t\right) + \frac{{N}_{c} \left(t\right) \left({c}_{max}\left(t\right)-{c}_{min}\left(t\right)\right)}{{N}_{m} \left(t\right)} + {σ}_{2} \left(t\right)$
where *c*₁(*t*) is a value of the individual learning factor after t iterations, *c*₂(*t*) is a value of the social learning factor after t iterations, *cₘₐₓ*(*t*) is a preset maximum value of the learning factor, and *cₘᵢₙ*(*t*) is a preset minimum value of the learning factor, *σ*₁(*t*) and *σ*₂(*t*) are perturbation factors. An initial value of the individual learning factor can be*cₘₐₓ*(*t*), and an initial value of the social learning factor can be *cₘᵢₙ*(*t*).

After each update of the velocity and position of each particle, a target loss function value is calculated based on a current velocity and position of the particle, and if a minimum value of the target loss function has not been reached, a step of updating the velocity and position of each particle in each iteration according to the following formula is returned, until the minimum value of the target loss function is obtained.

Before the start of iterative computation, an initial population of particles with a zero or an arbitrarily set velocity is randomly generated in D-dimensional space corresponding to the spatial dimensions. For example, when the total number of particles is 30, 28 particles may be set to represent inter-layer weights, and 2 particles may be set to represent biases. During iterative computation, particles continuously search for and update optimal positions by sharing position information within the swarm. With reference to mutation penetration cognition in a genetic algorithm, a random value is added to each particle's velocity within a specific range during each iteration of the algorithm. This approach ensures the randomness of the algorithm during a search process, thereby reducing a probability of low-velocity particles and enhancing an algorithm's capability to find a global optimum.

In one possible embodiment, during the use of the PSO algorithm, premature convergence of the particles may result in a large number of low-velocity particles clustering and becoming trapped in a local optimum, leading to a low penetration capability of particle movement. To be specific, the particles cannot cover larger dimensional space during optimization searching. For ease of description, in the present invention, these low-velocity particles are referred to as low-energy particles. In a possible implementation, when the low-energy particles appear during particle optimization, the low-energy particles may be replaced with high-energy particles, thereby improving a speed and penetration capability of particle optimization.

For example, the low-energy particles may be replaced using the following formula: ${v}_{ij} \left(t+1\right) = rand \left({v}_{min}, {v}_{max}\right) {δ}_{ij} \left(t\right)$ ${p}_{ij} \left(t+1\right) = rand \left({p}_{min}\left(t\right),{p}_{max}\left(t\right)\right) + {σ}_{ij} \left(t\right)$ $s . t . I ′ > {I}_{t} , {v}_{ij} \left(t\right) < {v}_{e} \left(t\right)$
where *vᵢⱼ*(*t +* 1) is an updated particle velocity, *vₘᵢₙ* is a minimum value among all particle velocities, *vₘₐₓ* is a maximum value among all particle velocities, *pᵢⱼ*(*t +* 1) is an updated particle position, *pₘᵢₙ*(*t*) is a minimum value among all particle positions, *pₘₐₓ*(*t*) is a maximum value among all particle positions, and *δᵢⱼ*(*t*) and *σᵢⱼ*(*t*) are the perturbation elements respectively. I' is a counting variable. Specifically, when a global optimal objective function value ${g}_{j}^{best}$ is not updated, *I*^{'} is counted, and *I*' is reset to 0 after ${g}_{j}^{best}$ update. *Iₜ* is an iteration threshold, and *vₑ*(*t*) is a velocity threshold, namely, a penetration effect threshold.

Through the above training process, specific values of the number of latent layers and the number of retention layers, as well as the inter-layer connection weights and biases among the network layers, can be obtained. The target swimming penetration neural network can be obtained based on network results and parameter values.

In one possible embodiment, the above environmental dataset may be divided into a training set and a validation set. An initial swimming penetration model is trained using the training set according to the above training process to obtain a target swimming penetration model, and a predictive effect of the target swimming penetration model is evaluated using the validation set. A proportion of environmental data included in the above training set and validation set can be set according to an actual application scenario.

In a possible implementation, a preset validation set may be used to evaluate the target swimming penetration neural network based on preset statistical indicators. The preset statistical indicators include an absolute error Ea of a stochastic mean field technique and a mean relative error Er. The absolute error of the stochastic mean field technique is calculated by the following formula: ${E}_{a} = \frac{1}{n} \sqrt{{\sum }_{i = 1}^{n} {c}_{i} {\left({y}_{i}-{e}_{i}\right)}^{2}} \times 100 %$
where *cᵢ* is a preset prediction standard coefficient, *yᵢ* is the error label corresponding to the environmental data, *eᵢ* is a predicted error value, and n is the number of environmental data entries input to the target swimming penetration neural network.

The mean relative error is calculated by the following formula: ${E}_{r} = \frac{1}{n} \sqrt{{\sum }_{i = 1}^{n} \frac{{c}_{i} {\left({y}_{i}-{e}_{i}\right)}^{2}}{{y}_{i}}} \times 100 %$

When the preset statistical indicators are less than preset thresholds, it is determined that the training of the target swimming penetration neural network is completed.

By applying the embodiment of the present invention, the error prediction algorithm for the electronic current transformer based on the swimming penetration neural network can be used to perform a data mining task, to implement error analysis of online digital intelligent monitoring data by the electronic current transformer in the swimming penetration neural network, obtaining a trend of error variation. The intelligent digital monitoring data of the ratio difference and the phase difference are compared, thereby implementing calibration of the electronic current transformer in the swimming penetration neural network. In addition, based on offline calibration data of the electromagnetic current transformer in the swimming penetration neural network, error correction is used to optimize a system error introduced by the magnetic current transformer in the swimming penetration neural network, thus implementing more accurate and fair metering.

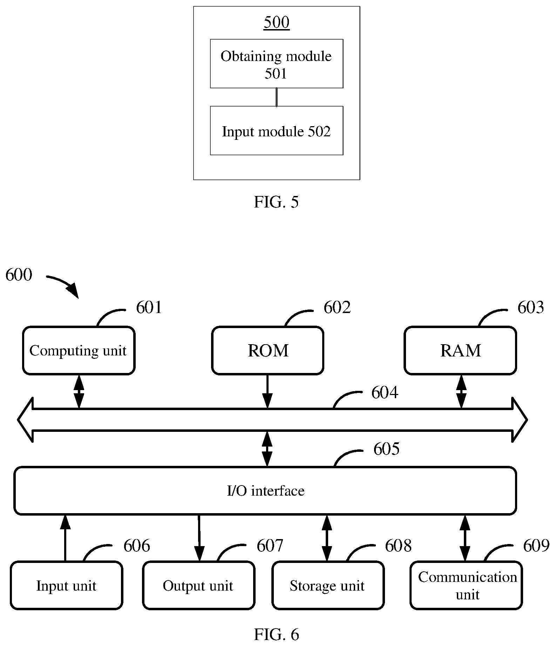

Based on the same inventive concept, an embodiment of the present invention further provides an apparatus for online prediction of a measurement error of an electronic current transformer, as shown in FIG. 5. The device 500 may include:
an obtaining module 501, configured to obtain target environmental data of an environment where a target electronic current transformer is located, where the target environmental data includes temperature data, humidity data, magnetic field data, and corrosion data; and
an input module 502, configured to input the target environmental data into a pre-trained target swimming penetration neural network to obtain an error prediction result output by a target error prediction model based on the target environmental data, where the error prediction result includes a ratio error prediction result and a phase error prediction result.

The target swimming penetration neural network is pre-trained in the following steps:
obtaining an environmental dataset, where each environmental data entry and an error label of the electronic current transformer corresponding to each environmental data entry are included in the environmental dataset;
inputting each environmental data entry in the environmental dataset into an initial swimming penetration neural network to obtain a predicted error output by the initial swimming penetration neural network, where the initial swimming penetration neural network includes an input layer, a latent layer, a retention layer, and an output layer, and the retention layer is used to receive an output from the latent layer and store an output from the latent layer in a previous iteration; and
training parameters in the initial swimming penetration neural network based on a difference between the predicted error and the error label corresponding to the environmental data until the difference converges, thereby obtaining the target swimming penetration neural network, where the parameters include inter-layer connection weights between network layers and biases in the network layers.

An exemplary embodiment of the present invention further provides an electronic device, including: at least one processor; and a memory communicatively connected to the at least one processor. The memory stores a computer program executable by the at least one processor, where when the computer program is executed by the at least one processor, the electronic device is enabled to perform the method according to the embodiment of the present invention.

An exemplary embodiment of the present invention further provides a non-transitory computer-readable storage medium storing a computer program, where when the computer program is executed by a processor of a computer, the computer is enabled to perform the method according to the embodiment of the present invention.

An exemplary embodiment of the present invention further provides a computer program product, including a computer program, where when the computer program is executed by a processor of a computer, the computer is enabled to perform the method according to the embodiment of the present invention.

Refer to FIG. 6. A structural block diagram of an electronic device 600, which may serve as a server or client in the present invention, is now described, which can be an example of a hardware device applicable to various aspects of the present invention. The electronic device is intended to represent various forms of digital electronic computing devices, such as a laptop, a desktop computer, a workstation, a personal digital assistant, a server, a blade server, a mainframe, and other suitable computers. The electronic device may also represent various forms of mobile devices, such as a personal digital processor, a cellular phone, a smartphone, a wearable device, and other similar computing apparatuses. Components and connections, relationships, and functions of the components shown herein are merely exemplary and are not intended to limit the implementations of the present invention described and/or claimed herein.

As shown in FIG. 6, the electronic device 600 includes a computing unit 601, which may perform various proper actions and processing according to a computer program stored in a read-only memory (ROM) 602 or a computer program loaded from a storage unit 608 into a random access memory (RAM) 603. Various types of programs and data required for the operation of the electronic device 600 may also be stored in the RAM 603. The computing unit 601, the ROM 602, and the RAM 603 are interconnected via a bus 604. An input/output (I/O) interface 605 is also connected to the bus 604.

Multiple components in the electronic device 600 are connected to the I/O interface 605, including: an input unit 606, an output unit 607, a storage unit 608, and a communication unit 609. The input unit 606 may be any type of device capable of inputting information to the electronic device 600. The input unit 606 can receive input digital or character information and generate a key signal input related to a user setting and/or function control of the electronic device. The output unit 607 may be any type of device capable of presenting information, and may include but is not limited to a display, a speaker, a video/audio output terminal, a vibrator, and/or a printer. The storage unit 608 may include but is not limited to a magnetic disk and an optical disk. The communication unit 609 allows the electronic device 600 to exchange information/data with other devices via computer networks such as the Internet and/or various telecommunication networks, and may include but is not limited to a modem, a network card, an infrared communication device, a wireless communication transceiver and/or chipset, such as a Bluetooth^{™} device, a WiFi device, a WiMax device, a cellular communication device, and/or the like.

The computing unit 601 may be various general-purpose and/or dedicated processing components with processing and computing capabilities. Some examples of the computing unit 601 include but are not limited to a central processing unit (CPU), a graphics processing unit (GPU), various dedicated artificial intelligence (AI) computing chips, various computing units running machine learning model algorithms, a digital signal processor (DSP), and any suitable processor, controller, microcontroller, and the like. The computing unit 601 executes the methods and processes described above. For example, in some embodiments, the method for online prediction of a measurement error of the electronic current transformer described in any of the above may be implemented as a computer software program, which is tangibly contained in a machine-readable medium, such as the storage unit 608. In some embodiments, some or all of the computer program may be loaded and/or installed onto the electronic device 600 via the ROM 602 and/or the communication unit 609. In some embodiments, the computing unit 601 may be configured to execute the method for online prediction of a measurement error of the electronic current transformer described in any of the above by any other suitable means (for example, by means of firmware).

A program code for implementing the method in the present invention may be written in any combination of one or more programming languages. These program codes may be provided to a processor or controller of a general-purpose computer, a special-purpose computer, or another programmable data processing apparatus, so that the program code, when executed by the processor or controller, implements the functions/operations specified in the flow chart and/or block diagram. The program code can be executed entirely on a machine, partially on a machine, partially on a machine and partially on a remote machine or completely on a remote machine or server as a stand-alone software package.

In the context of the present invention, the machine readable medium may be a tangible medium that may contain or store a program for use by or in conjunction with an instruction executing system, apparatus or device. The machine readable medium may be a machine readable signal medium or a machine readable storage medium. The machine readable medium may include, but is not limited to, an electronic, a magnetic, an optical, an electromagnetic, an infrared, or semiconductor system, apparatus, or device, or any suitable combination of the above. A more specific example of the machine-readable storage medium includes an electrical connection based on one or more wires, a laptop disk, a hard disk, a random access memory (RAM), a read-only memory (ROM), an erasable programmable read-only memory (EPROM or flash memory), an optical fiber, a compact disk read-only memory (CD-ROM), an optical storage device, a magnetic storage device, or any proper combination thereof.

As used in the present invention, the terms "machine-readable medium" and "computer-readable medium" mean any computer program product, device, and/or apparatus (such as a disk, an optical disk, a memory, a programmable logic device (PLD)) that is used to provide machine instructions and/or data to a programmable processor, including a machine-readable medium that receives machine instructions as a machine-readable signal. The term "machine-readable signal" means any signal used to provide the machine instructions and/or data to the programmable processor.

To provide user interaction, the system and technology described herein may be implemented on a computer, and the computer includes: a display apparatus (for example, a CRT (cathode ray tube) or LCD (liquid crystal display) monitor) for displaying information to the user; and a keyboard and pointing apparatus (for example, a mouse or trackball), through which the user may provide input to the computer. Other types of apparatuses may also be configured to provide user interaction. For example, feedback provided to the user may be any form of sensory feedback (such as visual feedback, auditory feedback, or tactile feedback); and input from the user may be received in any form (including voice input, speech input, or tactile input).

The systems and technology described herein may be implemented in a computing system including a backend component (such as a data server), or a computing system (such as an application server) including a middleware component, a computing system (such as a user computer with a graphical user interface or web browser, through which the user may interact with implementations of the system and technology described herein) including a frontend component, or a computing system including any combination of such backend component, middleware component, or frontend component. The components of the system may be interconnected by any form or medium of digital data communication (such as a communication network). Examples of the communication network include: a local area network (LAN), a wide area network (WAN), and the Internet.

The computer system may include a client and a server. The client and server are usually remote from each other and typically interact via the communication network. A client-server relationship is established by running a computer program with a client-server relationship on a corresponding computer.

## Claims

1. A method for online prediction of a measurement error of an electronic current transformer, **characterized by** comprising:
obtaining target environmental data of an environment where a target electronic current transformer is located, wherein the target environmental data comprises temperature data, humidity data, magnetic field data, and corrosion data; and
inputting the target environmental data into a pre-trained target swimming penetration neural network to obtain an error prediction result output by a target error prediction model based on the target environmental data, wherein the error prediction result comprises a ratio error prediction result and a phase error prediction result;
the target swimming penetration neural network is pre-trained in the following steps:
obtaining an environmental dataset, wherein each environmental data entry and an error label of the electronic current transformer corresponding to each environmental data entry are comprised in the environmental dataset;
inputting each environmental data entry in the environmental dataset into an initial swimming penetration neural network to obtain a predicted error output by the initial swimming penetration neural network, wherein the initial swimming penetration neural network comprises an input layer, a latent layer, a retention layer, and an output layer, and the retention layer is used to receive an output from the latent layer and store an output from the latent layer in a previous iteration; and
training parameters in the initial swimming penetration neural network based on a difference between the predicted error and the error label corresponding to the environmental data until the difference converges, thereby obtaining the target swimming penetration neural network, wherein the parameters comprise inter-layer connection weights between network layers and biases in the network layers.

2. The method according to claim 1, **characterized in that** the obtaining an environmental dataset comprises:
obtaining historically acquired operating status data of the electronic current transformer and corresponding environmental data, wherein the operating status data comprises a ratio difference and a phase difference of the electronic current transformer; and
filtering out an erroneous value and outlier from the operating status data of the electronic current transformer according to a preset filtering rule, to obtain filtered operating status data and corresponding environmental data, which form the environmental dataset, wherein the erroneous value means operating status data that appears consecutively more than a preset times threshold, and the outlier means operating status data whose difference from another piece of operating status data exceeds a preset status difference threshold.

3. The method according to claim 1, **characterized in that** the initial swimming penetration neural network comprises multiple latent layers and multiple retention layers, each latent layer is in a one-to-one correspondence with each retention layer, and the training parameters in the initial swimming penetration neural network based on a difference between the predicted error and the error label corresponding to the environmental data comprises:
calculating a range of the number of latent layers based on the number of nodes in the input layer, the number of nodes in the output layer, and a preset node perturbation number, wherein the number of nodes in the input layer is the number of data types input to the input layer, the number of nodes in the output layer is the preset number of data types output by the output layer, and the preset node perturbation number is a constant within a preset value range;
obtaining candidate latent layer counts based on a range of the number of latent layers, wherein the candidate latent layer counts are all integer values within the range; and
for each of the candidate latent layer counts, calculating an error deviation value based on the predicted error and the error label corresponding to the environmental data, and determining a candidate latent layer count corresponding to a minimum error deviation value in error deviation values corresponding to each of the candidate latent layer counts as the target number of latent layers and the target number of retention layers.

4. The method according to claim 3, **characterized in that** the training parameters in the initial swimming penetration neural network based on a difference between the predicted error and the error label corresponding to the environmental data further comprises:
setting spatial dimensions of the inter-layer connection weights and bias particles, and using a particle swarm algorithm to determine optimal values of the inter-layer connection weights and optimal values of the biases, wherein spatial dimensions of the inter-layer connection weights and the bias particles and the total number of particles are determined by the following formulas: ${S}_{N} \left(t\right) = {n}_{h} \left(t\right) \left({r}_{1}{n}_{in}\left(t\right)+{r}_{2}{n}_{out}\left(t\right)+{n}_{h}\left(t\right)+1\right) + {r}_{2} {n}_{out} \left(t\right)$ $P \left(t\right) = int \left({r}_{1}+{r}_{2}\sqrt{{S}_{N} \left(t\right)}\right)$
wherein *S_{N}*(*t*) is the spatial dimensions, *nₕ*(*t*) is the target number of the latent layers, *n*ᵢₙ(*t*) is the number of nodes in the input layer, *n*ₒᵤₜ(*t*) is the number of nodes in the output layer, r1 and r2 are random numbers; and *P*(*t*) is the total number of particles.

5. The method according to claim 4, **characterized in that** the using a particle swarm algorithm to determine optimal values of the inter-layer connection weights and optimal values of the biases comprises:
generating multiple particles in space corresponding to the spatial dimensions, wherein the total number of multiple particles is the number of particles; and
updating a velocity and position of each particle in each iteration according to the following formulas: ${v}_{ij} \left(t+1\right) = {wv}_{ij} \left(t\right) + {c}_{1} {r}_{1} \left[{p}_{ij}^{best}\left(t\right)-{p}_{ij}\left(t\right)\right] + {c}_{2} {r}_{2} \left[{g}_{j}^{best}\left(t\right)-{p}_{ij}\left(t\right)\right] + {δr}_{3} \left(t\right)$ ${p}_{ij} \left(t+1\right) = {p}_{ij} \left(t\right) + {v}_{ij} \left(t+1\right)$
wherein i is the number of particles, j is the spatial dimensions, vᵢⱼ(t) is a velocity of the particle after t iterations, pᵢⱼ(t) is a position of the particle after t iterations, ${p}_{ij}^{best} \left(t\right)$ is a j-th dimension value of an i-th particle's extremum, ${g}_{j}^{best} \left(t\right)$ is a j-th dimension value of a global optimal position, r₁, r₂, r₃ are random numbers in [0,1]; c₁ is an individual learning factor, c₂ is a social learning factor, w is an inertia weight, and δ is a random influence factor;
the inertia weight is iterated according to the following formula: $w \left(t\right) = \left({w}_{max}-{w}_{min}\right) \frac{{N}_{c} \left(t\right)}{{N}_{m} \left(t\right)} + {w}_{max} + σ \left(t\right)$
wherein w(t) is the inertia weight after t iterations, *wₘₐₓ* is a preset maximum value of the inertia weight, *wₘᵢₙ* is a preset minimum value of the inertia weight, *N_{c}*(*t*) is the current number of iteration steps, Nₘ (t) is the preset maximum number of iteration steps, and *σ*(*t*) is a random perturbation value;
the individual learning factor and the social learning factor are iterated according to the following formulas: ${c}_{1} \left(t\right) = {c}_{max} \left(t\right) - \frac{{N}_{c} \left(t\right) \left({c}_{max}\left(t\right)-{c}_{min}\left(t\right)\right)}{{N}_{m} \left(t\right)} + {σ}_{1} \left(t\right)$ ${c}_{2} \left(1\right) = {c}_{min} \left(t\right) + \frac{{N}_{c} \left(t\right) \left({c}_{max}\left(t\right)-{c}_{min}\left(t\right)\right)}{{N}_{m} \left(t\right)} + {σ}_{2} \left(t\right)$
wherein *c*₁(*t*) is a value of the individual learning factor after t iterations, *cₘₐₓ*(*t*) is a preset maximum value of the learning factor, and *σ*₁(*t*) and *σ*₂(*t*) are both perturbation factors; and
after each update of the velocity and position of each particle, a target loss function value is calculated based on a current velocity and position of the particle, and if a minimum value of the target loss function has not been reached, a step of updating the velocity and position of each particle in each iteration according to the following formula is returned, until the minimum value of the target loss function is obtained.

6. The method according to claim 5, **characterized in that** the inputting the target environmental data into a pre-trained target swimming penetration neural network to obtain an error prediction result output by a target error prediction model based on the target environmental data comprises:
outputting, by the target swimming penetration neural network, the error prediction result according to the following function: $y \left(k, t\right) = {g}^{1} \left({ω}_{3}\left(u\left(k, t\right)\right)\right) + σ \left(k, t\right)$ $u \left(k, t\right) = {g}^{2} \left({ω}_{1}{u}_{c}\left(k, t\right)+{ω}_{2}x\left(k-1,t\right)\right) + σ \left(k, t\right)$ ${u}_{c} \left(k, t\right) = u \left(k-1,t\right)$
wherein *y*(*k, t*) is an output of the target swimming penetration neural network, *x*(*k -* 1, *t*) is the target environmental data, *u*(*k, t*) is an output amount from the latent layer, *u_{c}*(*k, t*) is an output amount from the latent layer to the retention layer, *ω*₁ and *ω*₂ are the inter-layer connection weights, k is the number of iterations, *g*¹() is a neuron activation function of the output layer, g²() is a neuron activation function of the latent layer, and *σ*(*k, t*) is a perturbation function.

7. The method according to claim 5, **characterized in that** the method further comprises:
using a preset validation set to evaluate the target swimming penetration neural network based on preset statistical indicators, wherein the preset statistical indicators comprise an absolute error Ea of a stochastic mean field technique and a mean relative error Er, and the absolute error of the stochastic mean field technique is calculated by the following formula: ${E}_{a} = \frac{1}{n} \sqrt{{\sum }_{i = 1}^{n} {c}_{i} {\left({y}_{i}-{e}_{i}\right)}^{2}} \times 100 %$
wherein *cᵢ* is a preset prediction standard coefficient, *yᵢ* is the error label corresponding to the environmental data, *eᵢ* is a predicted error value, and n is the number of environmental data entries input to the target swimming penetration neural network; and
the mean relative error is calculated by the following formula: ${E}_{r} = \frac{1}{n} \sqrt{{\sum }_{i = 1}^{n} \frac{{c}_{i} {\left({y}_{i}-{e}_{i}\right)}^{2}}{{y}_{i}}} \times 100 %$
when the preset statistical indicators are less than preset thresholds, it is determined that the training of the target swimming penetration neural network is completed.

8. An apparatus for online prediction of a measurement error of an electronic current transformer, **characterized in that** the apparatus comprises:
an obtaining module, configured to obtain target environmental data of an environment where a target electronic current transformer is located, wherein the target environmental data comprises temperature data, humidity data, magnetic field data, and corrosion data; and
an input module, configured to input the target environmental data into a pre-trained target swimming penetration neural network to obtain an error prediction result output by a target error prediction model based on the target environmental data, wherein the error prediction result comprises a ratio error prediction result and a phase error prediction result, wherein
the target swimming penetration neural network is pre-trained in the following steps:
obtaining an environmental dataset, wherein each environmental data entry and an error label of the electronic current transformer corresponding to each environmental data entry are comprised in the environmental dataset;
inputting each environmental data entry in the environmental dataset into an initial swimming penetration neural network to obtain a predicted error output by the initial swimming penetration neural network, wherein the initial swimming penetration neural network comprises an input layer, a latent layer, a retention layer, and an output layer, and the retention layer is used to receive an output from the latent layer and store an output from the latent layer in a previous iteration; and
training parameters in the initial swimming penetration neural network based on a difference between the predicted error and the error label corresponding to the environmental data until the difference converges, thereby obtaining the target swimming penetration neural network, wherein the parameters comprise inter-layer connection weights between network layers and biases in the network layers.

9. An electronic device, comprising:
a processor; and
a memory storing a program,
wherein the program comprises instructions that, when executed by the processor, cause the processor to perform the method according to any one of claims 1 to 7.

10. A non-transitory computer-readable storage medium storing computer instructions, wherein the computer instructions are used for causing a computer to perform the method according to any one of claims 1 to 7.
